Europäisches Patentamt

European Patent Office

Office européen des brevets

(19)

(11) Numéro de publication: **0 165 182**
**A1**

## DEMANDE DE BREVET EUROPEEN

(12)

(21) Numéro de dépôt: **85420082.1**

(22) Date de dépôt: **07.05.85**

(51) Int. Cl.⁴: **H 04 M 1/02**

(30) Priorité: **11.05.84 FR 8407975**

(43) Date de publication de la demande:
**18.12.85 Bulletin 85/51**

(84) Etats contractants désignés:
**AT BE CH DE GB IT LI LU NL SE**

(71) Demandeur: **HORLOGERIE PHOTOGRAPHIQUE FRANCAISE**
**Le Bouchet**
**F-74130 Bonneville(FR)**

(72) Inventeur: **Montenot, Jean**
**Buisson Rond**
**F-74250 Fillinges(FR)**

(74) Mandataire: **de Beaumont, Michel**
**Cabinet Poncet B.P. 317**
**F-74008 Annecy Cédex(FR)**

(54) Dispositif électronique modulaire à modules enfichables autocodes.

(57) Le dispositif comprend plusieurs éléments modulaires adaptables (1, 7) sur un élément principal (5), l'adaptation s'effectuant au moyen de connecteurs électriques assurant des premières connexions électriques de type parallèle entre les organes fonctionnels des modules et le circuit de l'élément principal pour la transmission d'informations. les connecteurs électriques assurent en outre des secondes connexions en cascade formant une ligne spécialisée, enter la sortie spécialisée (14) d'un élément et l'entrée spécialisée (15) correspondante d'un élément suivant. Chaque élément reçoit sur son entrée spécialisée un numéro d'ordre ou adresse qui lui est attribué par l'élément précédent, et comporte un moyen générateur de numéros d'ordre (17) pour générer, en fonction de son propre numéro d'ordre, le numéro d'ordre suivant qui est transmis sur sa sortie spécialisée (16) à l'élément suivant (7).

EP 0 165 182 A1

./...

FIG. 1

DISPOSITIF ELECTRONIQUE MODULAIRE A MODULES ENFICHABLES AUTOCODES

La présente invention concerne les dispositifs électroniques dans lesquels un élément principal peut recevoir un ou plusieurs éléments secondaires sous forme de modules enfichables. Plus précisément, l'invention se rapporte à de tels dispositifs électroniques à circuit logique dans lesquels des composants tels que des touches, des voyants lumineux, sont gérés par un circuit logique de commande auquel ils sont reliés par des lignes de transmission de messages. L'aiguillage des messages entre l'unité de commande et les organes commandés s'effectue au moyen d'adresses affectées à chaque moyen commandé.

Dans de nombreuses applications on cherche à rendre les ensembles plus flexibles en prévoyant des sous-ensembles connectables à volonté, et par exemple des éléments secondaires sous forme de modules enfichables sur un élément principal. Généralement l'enfichage se fait au moyen de connecteurs électriques assurant des premières connexions électriques de type parallèle entre les circuits internes des modules et le circuit de l'élément principal pour la transmission des informations. L'adressage des informations véhiculées par les connexions de type parallèle est effectué au moyen des adresses ou numéros d'ordre affectés à chaque élément secondaire ou module.

Toutefois, dans le cas des dispositifs de ce type, c'est à dire à adressage et modulaire, toutes modifications de configuration par adjonction ou retrait d'un module nécessite de modifier le programme d'adressage contenu dans l'unité centrale de contrôle. Il en résulte que ces modifications sont relativement délicates, et que les modules sont difficilement interchangeables.

La présente invention a notamment pour objet d'éviter les inconvénients des dispositifs connus en proposant des moyens pour permettre l'enlèvement ou l'adaptation d'un module supplémentaire sans nécessiter de la part de l'utilisateur aucune opération de modification d'adressage. Les modules, dès leur mise en place, reçoivent de façon automatique un numéro d'ordre ou adresse qui dépend de leur position physique dans le dispositif global. Le dispositif de la présente invention permet ainsi de reconnaître la présence d'un module donné, de reconnaître sa position, de définir éventuellement ses fonctions selon sa position, et de modifier le programme d'adressage de façon automatique à chaque modification de configuration.

- 2 -                                    0165182

L'invention s'applique notamment à la réalisation de
répertoires téléphoniques extensibles et modulaires, les modules étant
enfichables et pouvant comprendre des moyens de signalisation. Il est
nécessaire pour cela de pouvoir s'adresser au module quelle que soit
sa position sans avoir à modifier le programme de l'unité centrale de
commande.

Pour atteindre ces objets ainsi que d'autres, la présente invention prévoit une architecture modulaire dans laquelle les
modules secondaires sont enfichables au moyen de connecteurs électriques assurant les premières connexions électriques de type parallèle
pour la transmission d'informations. Les connecteurs électriques assurent en outre des secondes connexions en cascade formant une ligne
spécialisée, les connexions s'effectuant entre une sortie spécialisée
d'un élément ou module et l'entrée spécialisée correspondante d'un élément suivant ; chaque élément reçoit sur son entrée spécialisée un numéro d'ordre ou adresse qui lui est attribué par l'élément précédent et
comporte un moyen générateur de numéros d'ordre pour générer, en fonction
de son propre numéro d'ordre, le numéro d'ordre suivant qui est transmis
sur sa sortie spécialisée à l'élément suivant.

D'autres aspects, caractéristiques et avantages de la
présente invention ressortiront de la description suivante, d'un mode
de réalisation particulier, faite en relation avec les figures jointes,
parmi lesquelles :
- la figure 1 représente schématiquement l'organisation interne du circuit électrique d'un module enfichable selon la présente invention ; et
- la figure 2 représente un mode de réalisation d'un générateur de numéros d'ordre.

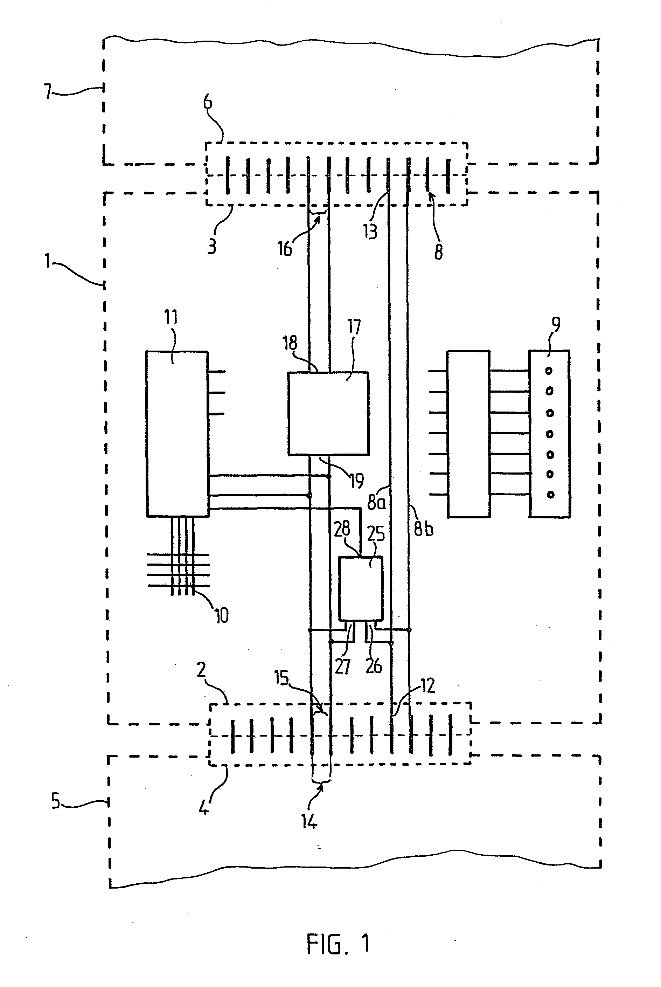

Dans le mode de réalisation représenté sur la figure 1,
plusieurs éléments modulaires sont connectés en cascade. Un élément
modulaire 1 comprend un connecteur électrique d'entrée 2 et un connecteur de sortie 3. Le connecteur d'entrée 2 de l'élément 1 est adaptable
sur un connecteur de sortie 4 d'un élément précédent 5. Le connecteur
de sortie 3 est adaptable sur un connecteur d'entrée 6 d'un élément
suivant 7. Ainsi les éléments successifs 5, 1, 7 peuvent être empilés
les uns contre les autres.

Les connecteurs électriques assurent la connexion de
deux types de ligne. Un premier ensemble de lignes 8, de type parallèle, sert à l'adressage et à la transmission des informations véhiculées entre les modules et une unité de contrôle centrale non représentée sur les figures. Il s'agit de transmissions de type connu, qu'il est donc inutile de décrire complètement dans le présent exposé. Les lignes de type parallèle assurent notamment les connexions avec les organes fonctionnels internes du module, par exemple une série de voyants 9, un clavier 10, notamment par l'intermédiaire d'une unité de contrôle interne 11. Les messages véhiculés sur les lignes parallèles 8 contiennent une partie informations et une partie adresses correspondant aux différents organes fonctionnels en activité.

Les bornes respectives correspondantes de type parallèle des connecteurs d'entrée 2 et de sortie 3 d'un élément 1 sont connectées directement l'une à l'autre, et par exemple les bornes extrêmes 12 et 13.

Les connecteurs assurent la connexion d'un second type de lignes, ou lignes spécialisées, la connexion étant du type cascade. Les connecteurs assurent ainsi la connexion entre une sortie spécialisée 14 d'un élément 5 et l'entrée spécialisée correspondante 15 d'un élément suivant 1. Les bornes respectives de l'entrée spécialisée 15 et de la sortie spécialisée 16 d'un même élément 1 sont connectées par l'intermédiaire d'un moyen générateur de numéros d'ordre 17.

Le moyen générateur de numéros d'ordre 17 est un circuit logique dont la sortie 18 émet des signaux électriques représentant un certain nombre binaire lorsque son entrée 19 reçoit des signaux électriques représentant le nombre binaire précédent. C'est un circuit logique de type incrémenteur, assurant par exemple un incrément d'une unité.

Chaque élément, par exemple l'élément 1, reçoit sur son entrée spécialisée 15 un numéro d'ordre ou adresse qui lui est attribué par l'élément précédent 5. Le générateur de numéros d'ordre 17 génère, en fonction du numéro d'ordre présent sur l'entrée 15, le numéro d'ordre suivant qui est transmis par la sortie 16 à l'élément suivant 7.

Les unités de contrôle internes 11 sont également connectées aux entrées spécialisées 15 pour recueillir l'information représentant l'adresse du module ou élément correspondant 1. Ainsi l'élément 1 saura reconnaître sur les lignes parallèles 8 les informations qui le concernent, et saura éventuellement envoyer sur les lignes 8 l'information selon laquelle il est présent à telle adresse.

Pour reconnaître les adresses, une solution consiste à utiliser un comparateur logique 25 de deux signaux à deux bits, dont une première entrée 26 est connectée à deux fils 8a et 8b des lignes parallèles 8, les fils 8a et 8b étant spécialisés pour la transmission des adresses. La seconde entrée 27 du comparateur 25 est connectée aux entrées spécialisées 15, et sa sortie 28 est connectée à l'unité de contrôle interne 11.

La présente invention s'applique notamment à la réalisation de postes téléphoniques, comprenant un boîtier principal, par exemple constitué par l'élément 5, connecté au réseau téléphonique non représenté sur la figure. Des éléments modulaires 1 et 7 sont connectables comme décrit précédemment, ces éléments modulaires comprenant des touches de contrôle 10, des moyens lumineux 9 de signalisation, l'ensemble de ces organes fonctionnels étant gérés par le boîtier principal 5, et leur adresse dépendant du numéro d'ordre de l'élément modulaire correspondant 1 ou 7. On peut ainsi réaliser des répertoires téléphoniques modulaires adaptables sur le poste téléphonique.

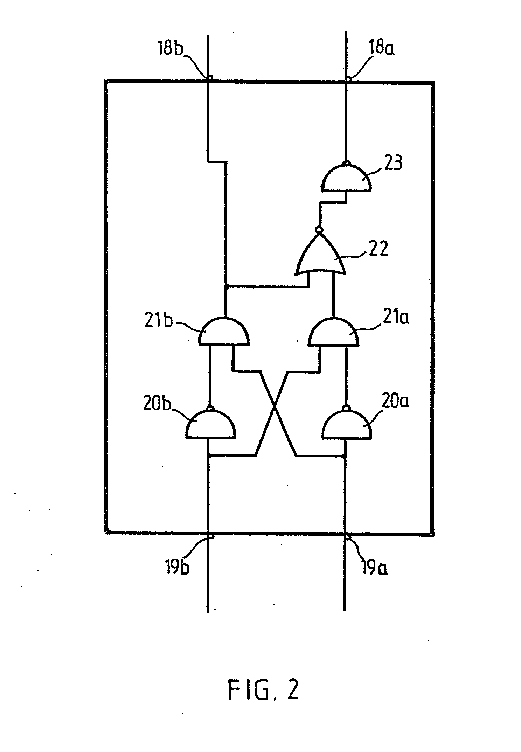

A titre d'exemple, on a représenté sur la figure 2 un mode de réalisation du circuit générateur du numéro d'ordre 17. Dans ce mode de réalisation, les numéros d'ordre sont transmis par une ligne à deux fils codés en binaire. Chacune des entrées 19a, 19b est connectée à l'entrée respective d'une première porte logique 20a et 20b dont la sortie est connectée à une première entrée respective d'une seconde porte 21a et 21b à deux entrées. La seconde entrée de la porte 21a est connectée à la borne 19b et la seconde entrée de la porte 21b est connectée à la borne 19a. La sortie de la porte 21b est connectée à la borne de sortie 18b du générateur et à une première borne d'entrée d'une troisième porte 22 à deux entrées dont la seconde entrée est connectée à la sortie de la porte 21a. La sortie de la porte 22 est connectée à l'entrée d'une quatrième porte 23 dont la sortie est connectée à la borne de sortie 18a du générateur 17.

Les premières portes 20a et 20b sont du type ET NON, les secondes portes 21a et 21b sont du type ET, la troisième porte 22 est du type OU NON, et la quatrième porte 23 est du type ET NON.

La présente invention n'est pas limitée aux modes de réalisation qui ont été explicitement décrits, mais elle en inclut les diverses variantes et généralisations contenues dans le domaine des revendications ci-après.

REVENDICATIONS

1 - Dispositif électronique modulaire, comprenant un élément principal (5) sur lequel s'adaptent des éléments secondaires (1, 7) sous forme de modules enfichables au moyen de connecteurs électriques assurant des premières connexions (8) électriques de type parallèle entre des organes fonctionnels (10, 9) des modules et le circuit de l'élément principal (5) pour la transmission d'informations, l'adressage des informations véhiculées par les connexions de type parallèle (8) étant effectué au moyen d'adresses ou numéros d'ordre affectés à chaque élément, caractérisé en ce que les connecteurs électriques assurent des secondes connexions en cascade formant une ligne spécialisée entre une sortie spécialisée (14) d'un élément (5) et l'entrée spécialisée (15) correspondante d'un élément suivant (1), chaque élément recevant sur son entrée spécialisée (15) un numéro d'ordre ou adresse qui lui est attribué par l'élément précédent (5) et comportant un moyen générateur de numéros d'ordre (17) pour générer, en fonction de son propre numéro d'ordre, le numéro d'ordre suivant qui est transmis sur sa sortie spécialisée (16) à l'élément suivant (7).

2 - Dispositif selon la revendication 1, caractérisé en ce que chaque élément modulaire comprend un connecteur d'entrée (2) et un connecteur de sortie (3), le connecteur d'entrée (2) d'un élément (1) étant adaptable sur le connecteur de sortie (4) de l'élément précédent (5), de sorte que les éléments peuvent être empilés les uns contre les autres.

3 - Dispositif selon la revendication 2, caractérisé en ce que les bornes respectives correspondantes (12, 13) des connecteurs d'entrée et de sortie (2, 3) d'un élément (1) sont connectées directement l'une à l'autre, les bornes respectives correspondantes spécialisées de type cascade (15, 16) étant connectées par l'intermédiaire d'un moyen générateur de numéros d'ordre (17).

4 - Dispositif selon l'une quelconque des revendications 1 à 3, caractérisé en ce que le moyen générateur de numéros d'ordre (17) est un circuit logique dont la sortie (18) émet des signaux électriques représentant un certain nombre binaire lorsque son entrée (19) reçoit des signaux électriques représentant le nombre binaire précédent.

5 - Poste téléphonique, comprenant un boîtier principal (5) connecté au réseau téléphonique, caractérisé en ce qu'il comprend des éléments modulaires (1, 7) connectables selon l'une quelconque des revendications 1 à 4, les éléments modulaires comprenant des touches de contrôle (10) et des moyens lumineux (9) de signalisation gérés par le boîtier principal (5) et dont l'adresse dépend du numéro d'ordre de l'élément modulaire correspondant (1).

0165182

1 / 2

FIG. 1

FIG. 2

Office européen
des brevets

**RAPPORT DE RECHERCHE EUROPEENNE**

**0165182**
Numero de la demande

EP  85 42 0082

## DOCUMENTS CONSIDERES COMME PERTINENTS

| Catégorie | Citation du document avec indication, en cas de besoin des parties pertinentes | Revendication concernée | CLASSEMENT DE LA DEMANDE (Int Cl 4) |
|---|---|---|---|
| A | US-A-3 916 103  (MORRELL)<br>* Colonne 2, ligne 5 - colonne 3, ligne 45; figures * | 1 | H 04 M    1/02 |
| | --- | | |
| A | DE-B-1 223 889  (SIEMENS & HALSKE)<br>* Colonne  4, ligne 48 - colonne 6, ligne 12; figures * | 1 | |
| | ----- | | |

|  |
|---|
| DOMAINES TECHNIQUES RECHERCHES (Int. Cl.4) |
| H 04 M |

Le présent rapport de recherche a été établi pour toutes les revendications

| Lieu de la recherche | Date d'achèvement de la recherche | Examinateur |
|---|---|---|
| LA HAYE | 19-08-1985 | KEPPENS P.M.R. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82